# EUROPÄISCHE PATENTSCHRIFT

(11) **EP 3 651 362 B1**
(45) Veröffentlichungstag und Bekanntmachung des Hinweises auf die Patenterteilung: **29.07.2026**
(21) Anmeldenummer: 19207527.3
(22) Anmeldetag: 06.11.2019
(51) Int. Cl.: H03K 17/955, H03K 17/96

(54) **SENSORANORDNUNG**
SENSOR ARRANGEMENT
DISPOSITIF DE CAPTEUR

(30) Priorität: 06.11.2018 DE 102018127683
(43) Veröffentlichungstag der Anmeldung: 13.05.2020
(73) Patentinhaber: Huf Hülsbeck & Fürst GmbH & Co. KG, 42551 Velbert (DE)
(72) Erfinder: Bitirim, Serdal, 42549 Velbert (DE); Wölki, Lennart, 42555 Velbert (DE)
(74) Vertreter: Bals & Vogel Patentanwälte PartGmbB

(56) Entgegenhaltungen:
- EP-A1- 2 689 976
- EP-B1- 3 891 039
- WO-A1-2006/015724
- DE-A1- 102016 109 793
- DE-B3- 102011 003 734
- US-A1- 2016 349 908

## Beschreibung

Die vorliegende Erfindung betrifft eine Sensoranordnung zur kapazitiven Erfassung. Ferner bezieht sich die Erfindung auf eine Fahrzeugkomponente, ein Verfahren zur Auswertung der Sensoranordnung sowie ein Computerprogramm.

Es sind aus dem Stand der Technik eine Vielzahl von Anwendungsmöglichkeiten für elektronische Sensoranordnungen zur kapazitiven Erfassung bekannt. Insbesondere bei Fahrzeugen können derartige Sensoranordnungen eine komfortable Aktivierung von sicherheitsrelevanten Funktionen ermöglichen. So kann bspw. bei der Detektion einer Aktivierungshandlung wie einer Annäherung an das Fahrzeug mittels der kapazitiven Erfassung automatisch eine Authentifizierung zum Entriegeln des Fahrzeuges durchgeführt werden.

Problematisch ist hierbei, dass übliche Sensoranordnungen häufig lediglich als ein 1-Bit Sensor ausgeführt sind. In anderen Worten kann nur ein aktivierter von einem deaktivierten Zustand des Sensors unterschieden werden, um die Annäherung zu erkennen. Komplexe Aktivierungshandlungen wie Gesten können nur bei Nutzung weiterer technisch aufwendiger Maßnahmen erkannt werden. Auch ist die Fehlerkompensation bei solchen Sensoranordnungen ggf. noch problematisch, da Fehlereinflüsse wie Regen und Feuchtigkeit leicht zur Fehldetektion führen können.

Aus der Schrift DE 10 2011 003 734 B3 ist eine Elektrodenkonfiguration für eine kapazitive Sensoreinrichtung sowie kapazitive Sensoreinrichtung zur Annäherungsdetektion bekannt.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Sensoranordnung zur kapazitiven Erfassung bereitzustellen, welche insbesondere eine kostengünstigere und/oder zuverlässigere Fehlerkompensation bietet und/oder den technischen Aufwand zur Detektion komplexer Aktivierungshandlungen reduziert.

Die voranstehende Aufgabe wird gelöst durch die Patentansprüche, und insbesondere durch eine Sensoranordnung mit den Merkmalen des unabhängigen Vorrichtungsanspruchs, eine Fahrzeugkomponente mit den Merkmalen des weiteren unabhängigen Vorrichtungsanspruchs, ein Verfahren mit den Merkmalen des unabhängigen Verfahrensanspruchs sowie durch ein Computerprogramm mit den Merkmalen des Weiteren unabhängigen Vorrichtungsanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensoranordnung beschrieben sind, selbstverständlich auch im Zusammenhang mit der erfindungsgemäßen Fahrzeugkomponente, dem erfindungsgemäßen Verfahren sowie dem erfindungsgemäßen Computerprogramm, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Sensoranordnung, vorzugsweise in der Form einer elektronischen Schaltungsanordnung, für eine kapazitive Erfassung, insbesondere bei einem Fahrzeug. Beispielsweise kann die Sensoranordnung zur kapazitiven Erfassung bei einem Türgriff und/oder einem Emblem und/oder einem Schweller und/oder einem Stoßfänger des Fahrzeuges eingesetzt werden, und hierzu bevorzugt in den genannten Fahrzeugkomponenten (d. h. in dem Türgriff bzw. Emblem bzw. Schweller bzw. Stoßfänger) integriert sein. Auf diese Weise kann die Sensoranordnung dazu ausgeführt sein, eine Aktivierungshandlung in der Umgebung der Fahrzeugkomponente zu erfassen, wie eine Annäherung an die Fahrzeugkomponente mit der Sensoranordnung.

Die kapazitive Erfassung kann somit zur Detektion einer Aktivierungshandlung dienen, wie bspw. wenigstens eine Annäherung und/oder eine Geste und/oder wenigstens eine Berührung und/oder wenigstens eine Bewegung. Die Aktivierungshandlung kann dabei auch eine Kombination aus wenigstens einer Annäherung und/oder Berührung und/oder Bewegung und/oder dergleichen umfassen. Ein Beispiel für eine solche Kombination ist eine zumindest teilweise zeitgleiche Annäherung und/oder Berührung an verschiedenen Positionen (insbesondere verschiedene Sensorelemente) der Sensoranordnung. Ein anderes Beispiel ist eine Annäherung und/oder Berührung durch ein Aktivierungsmittel, und anschließende Bewegung des angenäherten und/oder berührenden Aktivierungsmittels in eine bestimmte Richtung. Das Aktivierungsmittel ist hierbei bspw. ein Finger oder dergleichen, welcher einen Einfluss auf eine veränderliche Kapazität bei der Sensoranordnung hat.

Um die kapazitive Erfassung ein- oder mehrfach bereitzustellen, kann für jede kapazitive Erfassung ein Sensorelement vorgesehen sein. Dies ermöglicht es, die Aktivierungshandlung durch die wenigstens eine kapazitive Erfassung zuverlässig zu detektieren. Dabei ist vorzugsweise das Sensorelement jeweils als ein elektrisch leitfähiges Sensorelement ausgebildet, um jeweils die kapazitive Erfassung für eine Umgebung des Sensorelements bereitzustellen.

Es ist vorteilhafterweise vorgesehen, dass das (wenigstens eine) Sensorelement jeweils mit einer ortsauflösenden Geometrie ausgebildet ist, um eine ortsabhängige Information bei der Erfassung zu erhalten. Es können bspw. mindestens zwei oder mindestens drei Sensorelemente der Sensoranordnung vorgesehen sein, welche jeweils diese ortsauflösende Geometrie aufweisen. Darüber hinaus kann auch wenigstens ein weiteres Sensorelement der Sensoranordnung ohne diese ortsauflösende Geometrie vorgesehen sein, welche nachfolgend zur einfacheren Unterscheidung jeweils als Sensormittel bezeichnet werden.

Die Nutzung einer ortsauflösenden Geometrie hat dabei den Vorteil, dass durch eine einfache geometrische Anpassung der Form des Sensorelements der Funktionsumfang deutlich erweitert werden kann. So kann der üblicherweise nur eingeschränkt als Aktivierung und Deaktivierung auflösbare Zustand des Sensorelements erfindungsgemäß um einen weiteren Parameter der Ortsauflösung erweitert werden. In anderen Worten kann der Aktivierung des jeweiligen Sensorelements ein Ort am Sensorelement (d. h. die Position der Aktivierung, also Aktivierungsposition) und/oder eine weitere ortsabhängige Information wie eine Bewegungsrichtung der Aktivierung zugeordnet werden. Eine Lokalisierung dieses Ortes und/oder die Bewegungsrichtung und/oder eine Information über eine Geste und/oder eine absolute Position der Aktivierung und/oder eine Bewegungsinformation können dabei die (wenigstens eine) ortsabhängige Information sein, welche bei der Erfassung erhalten werden kann.

Die ortsauflösende Geometrie ist dabei vorteilhafterweise unabhängig von einer Position des Sensorelements an der Sensoranordnung und/oder am Fahrzeug. In anderen Worten kann der Ort (bzw. die ortsabhängige Information) eine Position am Sensorelement betreffen (und nicht des Sensorelements z. B. am Fahrzeug). Somit kann auch innerhalb des Sensorelements über die Ortsauflösung noch zwischen verschiedenen Aktivierungspositionen der Aktivierung des Sensorelements unterschieden werden.

Eine Aktivierung des jeweiligen Sensorelements erfolgt bspw. dadurch, dass eine Annäherung und/oder Berührung des Sensorelements an einer Aktivierungsposition am Sensorelement durchgeführt wird, welche vorzugsweise eine Veränderung einer veränderlichen Kapazität bewirkt. Diese veränderliche Kapazität wird z. B. dadurch durch das Sensorelement bereitgestellt, dass das Sensorelement als Elektrode gegenüber einer Umgebung und/oder Masse eine Kapazität ausbildet. In anderen Worten bildet das Sensorelement mit der Umgebung eine Art Kondensator, dessen Kapazität durch eine Annäherung und/oder Veränderung in der Umgebung verändert werden kann.

Eine Auswertung des jeweiligen Sensorelements ist vorteilhafterweise dadurch möglich, dass eine Übertragung einer elektrischen Ladung von dem Sensorelement an eine Verarbeitungsvorrichtung initiiert wird. Vorzugsweise wird diese elektrische Ladung in einem Kondensator (nachfolgend: Haltekondensator) der Verarbeitungsvorrichtung zwischengespeichert und/oder akkumuliert. Die Ladungsübertragung kann dabei wiederholt und/oder zyklisch durchgeführt werden. Anschließend kann die (ggf. akkumulierte) Ladung ausgewertet werden, z. B. quantitativ durch einen Analog-Digital-Wandler erfasst werden. Hierzu wird bspw. eine Spannung über den Haltekondensator erfasst, welche proportional zum Ladezustand des Haltekondensators ist. Anhand dieser Erfassung und/oder einer Zwischenspeicherung dieser Erfassung und/oder eines Vergleichs mit weiteren Erfassungen vorangegangener Ladungsübertragungen kann eine Veränderung einer Sensorkapazität ermittelt werden. Diese Sensorkapazität ist eine Kapazität, welche durch das Sensorelement gegenüber der Umgebung und/oder gegenüber einem Massepotential bereitgestellt wird. Entsprechend können Einflüsse in der Umgebung wie eine Annäherung ursächlich sein für die Veränderung, und daher die Aktivierung des Sensorelements bewirken. Hierauf bezieht sich insbesondere auch der Ausdruck "kapazitive Erfassung", da die Erfassung bei dem Sensorelement auf der Auswertung einer Veränderung der Sensorkapazität basiert. Wenn die Veränderung eine bestimmte Charakteristik aufweist, z. B. eine Schwelle überschreitet, kann somit die Aktivierung detektiert werden.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung (eines Aktivierungsmittels und/oder des ID-Gebers) an das Fahrzeug initiiert. Hierzu wird bspw. wiederholt und/oder bei Detektion der Annäherung durch eine erfindungsgemäße Sensoranordnung ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt.

Die Detektion der Annäherung und/oder die Initiierung einer Funktion des Fahrzeuges kann insbesondere durch die kapazitive Erfassung ausgelöst werden, wenn bei einer erfindungsgemäßen Sensoranordnung anhand der kapazitiven Erfassung eine Aktivierungshandlung, wie die Annäherung oder eine Geste oder eine Aktivierungskombination, detektiert wird. Daraufhin kann z. B. die Authentifizierung ausgelöst werden (z. B. durch das Aussenden des Wecksignals) und/oder die Fahrzeugbeleuchtung aktiviert werden und/oder eine sicherheitsrelevante Funktion wie das Entriegeln und/oder das Öffnen der Heck- und/oder Frontklappe (jeweils bei erfolgreicher vorangegangener Authentifizierung) initiiert werden.

Es kann im Rahmen der Erfindung vorgesehen sein, dass das Sensorelement jeweils als wenigstens eine elektrisch leitfähige Fläche, insbesondere an einer Leiterplatte, ausgebildet ist, um vorzugsweise eine veränderliche Kapazität (Sensorkapazität) für die kapazitive Erfassung bereitzustellen. Außerdem kann bevorzugt die ortsauflösende Geometrie als eine definierte geometrische Anpassung dieser Fläche ausgebildet sein, um die Veränderlichkeit der Kapazität ortsabhängig in definierter Weise anzupassen. Diese ortsabhängige Anpassung kann beispielsweise durch eine Asymmetrie und/oder Anpassung der Fläche hervorgerufen werden. Dies hat den Vorteil, dass eine Aktivierungshandlung wie eine Annäherung an verschiedene Positionen der Fläche unterschiedliche Auswirkungen auf die Veränderung der Kapazität hat. Diese unterschiedlichen Auswirkungen können beispielsweise durch unterschiedliche Signalamplituden eines Erfassungssignals identifiziert werden. Auf diese Weise sind die Unterschiede spezifisch für die Position der Aktivierung des Sensorelements, und erlauben somit z. B. durch eine Auswertung des Erfassungssignals eine Ortsauflösung bei dem Sensorelement.

Des Weiteren kann vorgesehen sein, dass das Sensorelement jeweils als eine dreieckige oder viereckige und/oder (im Wesentlichen) keilförmige Sensorelektrode ausgebildet ist. Alternativ oder zusätzlich kann ein erstes Sensorelement des wenigstens einen Sensorelements derart (insbesondere unmittelbar) benachbart zu einem zweiten Sensorelement des wenigstens einen Sensorelements angeordnet sein, dass das erste und zweite Sensorelement gemeinsam einen, insbesondere (zumindest im Wesentlichen) rechteckigen, Erfassungsbereich bereitstellen. Dies hat den Vorteil, dass die Sensorelemente gemeinsam einen Erfassungsbereich bereitstellen, welcher an eine Form einer Fahrzeugkomponente angepasst sein kann.

Darüber hinaus ist es vorteilhafterweise möglich, dass die ortsauflösende Geometrie dadurch bereitgestellt ist, dass das jeweilige Sensorelement unterschiedliche Ausdehnungen (jeweils in einer vorgegebenen Richtung) aufweist. Die Ausdehnung kann z. B. die Erstreckung des Sensorelements in einer zweiten Richtung als die vorgegebene Richtung sein, welche orthogonal zu einer ersten Richtung (eines Richtungsvektors) ist. Die Ausdehnung des Sensorelements parallel zur zweiten Richtung kann z. B. für unterschiedliche Positionen des Sensorelements entlang der ersten Richtung variieren. Damit kann z. B. die Ortsauflösung für die unterschiedlichen Positionen bereitgestellt werden, an denen jeweils das Sensorelement aktiviert werden kann. Dabei ist die Variation der Ausdehnungen signifikant für eine dadurch hervorgerufene Modifikation der Sensitivität des Sensorelements, um die verschiedenen Positionen der Aktivierung bei der Erfassung z. B. anhand der Auswertung eines Erfassungssignals unterscheiden zu können.

Es ist ferner denkbar, dass die ortsauflösende Geometrie als eine Asymmetrie und/oder als ungerader (und insbesondere unterschiedlicher) Verlauf von (gegenüberliegenden) Kanten einer aktiven Sensorfläche des jeweiligen Sensorelements ausgebildet ist, um an verschiedenen Positionen der Sensorfläche eine unterschiedliche, vorzugsweise graduell ansteigende, Veränderlichkeit einer Kapazität bei dem Sensorelement bereitzustellen, wobei die unterschiedliche Veränderlichkeit für die ortsabhängige Information spezifisch ist. Die aktive Sensorfläche ist dabei beispielsweise eine elektrisch leitfähige Fläche, welche eine Sensorelektrode zur Ausbildung einer Sensorkapazität bildet. Diese Fläche kann beispielsweise als Leiterbahn auf einer Leiterplatte ausgebildet sein. Ferner ist es denkbar, dass die Veränderlichkeit der Kapazität das Ausmaß der Kapazitätsveränderung der Sensorkapazität bei einer Aktivierung (wie einer Annäherung) des Sensorelements betrifft. So kann aufgrund der ortsauflösenden Geometrie das Ausmaß dieser Veränderung an unterschiedlichen Positionen des Sensorelements signifikant und/oder definiert unterschiedlich sein. Auf diese Weise können weitergehende Informationen über die Aktivierung, wie z. B. eine Bewegungsrichtung eines Aktivierungsmittels, erfasst werden.

Bevorzugt kann im Rahmen der Erfindung vorgesehen sein, dass das Sensorelement jeweils ortsabhängig mit unterschiedlicher, vorzugsweise graduell ansteigender und/oder vorgegebener, Sensitivität ausgebildet ist, um anhand der unterschiedlichen Sensitivität die ortsabhängige Information bereitzustellen. Die Sensitivität betrifft z. B. das Ausmaß einer Veränderung der Sensorkapazität bei Aktivierung des Sensorelements an einer bestimmten Position, und ist z. B. abhängig vom Ausmaß der aktiven Sensorfläche an dieser Position. Die Anpassung dieser Sensitivität für unterschiedliche Positionen des Sensorelements ermöglicht es dabei auf einfache Weise, eine ortsabhängige Information bei der Aktivierung des Sensorelements zu generieren.

Es kann ferner möglich sein, dass das wenigstens eine Sensorelement jeweils mit einer Verarbeitungsvorrichtung verschaltet ist, um die ortsabhängige Information durch eine elektrische Auswertung des jeweiligen Sensorelements zu ermitteln, insbesondere durch eine Auswertung einer veränderlichen Kapazität (Sensorkapazität), um vorzugsweise anhand der ortsabhängigen Information eine Geste und/oder eine Aktivierungskombination zu detektieren und/oder eine sicherheitsrelevante Funktion bei dem Fahrzeug zu aktivieren. Die Verschaltung kann z. B. dadurch erfolgen, dass das jeweilige Sensorelement über wenigstens eine Leiterbahn und über wenigstens einen elektronischen Schalter und/oder Umschalter mit der Verarbeitungsvorrichtung verbunden ist. Die Verarbeitungsvorrichtung weist z. B. eine Haltekapazität und/oder einen Mikrocontroller und/oder einen Analog-Digital-Wandler und/oder dergleichen auf, um die Auswertung durchzuführen. Die Gesten- und/oder Aktivierungskombinationen können z. B. eine bestimmte zeitliche Abfolge von Aktivierungen an unterschiedlichen Positionen des wenigstens einen Sensorelements betreffen. Auch kann es möglich sein, dass verschiedene des wenigstens einen Sensorelements gleichzeitig aktiviert werden, um eine Aktivierungskombination bereitzustellen. Auf diese Weise wird eine Vielzahl von Möglichkeiten bereitgestellt, um eine sicherheitsrelevante Funktion wie ein Entriegeln des Fahrzeuges zu aktivieren. Auf diese Weise kann durch eine einfache technische Anpassung die Sensoranordnung in vielfältiger Weise genutzt werden.

Ferner ist es denkbar, dass das wenigstens eine Sensorelement ein erstes und zweites Sensorelement aufweist, welche unmittelbar benachbart zueinander an einer Leiterplatte angeordnet sind, um durch beide Sensorelemente gemeinsam und insbesondere synergetisch die kapazitive Erfassung bereitzustellen, wobei die Sensorelemente hierzu vorzugsweise geometrisch komplementär zueinander angeordnet sind. Die synergetische Bereitstellung kann z. B. dadurch erfolgen, dass eines der beiden Sensorelemente als eine Referenz für das andere Sensorelement ausgeführt ist. Die Referenz ist z. B. nötig, um eine Bewegungsrichtung und/oder eine absolute Position der Aktivierung an wenigstens einem der Sensorelemente festzustellen.

Ein weiterer Vorteil kann im Rahmen der Erfindung erzielt werden, wenn eines oder wenigstens zwei des wenigstens einen Sensorelements jeweils vollflächig als eine elektrisch leitfähige und insbesondere potentialgleiche Fläche ausgebildet ist. Beispielsweise sind die Sensorelemente zumindest teilweise als Leiterfläche einer Leiterplatte der Sensoranordnung ausgebildet. Da es sich bevorzugt um eine einzige leitfähige Fläche handelt, ist diese somit potentialgleich ausgeführt, weist also ein gemeinsames elektrisches Potential auf. Insbesondere ermöglicht dies, zuverlässig eine Sensorelektrode zur Ausbildung einer veränderlichen Sensorkapazität bereitzustellen.

Des Weiteren kann vorgesehen sein, dass eines oder wenigstens zwei des wenigstens einen Sensorelements jeweils mehrere Segmente zur Ausbildung einer Segmentform aufweist, welche vorzugsweise als beabstandete Leiterflächen ausgebildet sind, und bevorzugt elektrisch miteinander verbunden und/oder potentialgleich sind. Diese einzelnen Segmente können z. B. über Leiterbahnen miteinander elektrisch verbunden sein und somit das gleiche Potential aufweisen. Ferner kann es möglich sein, dass die einzelnen Segmente jeweils eine von einer Dreieck- oder Keilform abweichen, jedoch gegebenenfalls so benachbart zueinander angeordnet sein, dass ein äußerer Umriss dieser gesamten Anordnung eine Dreieck- oder Keilform ausbildet und/oder die ortsauflösende Geometrie ausbildet.

Es ist ferner denkbar, dass eines oder wenigstens zwei des wenigstens einen Sensorelements jeweils elektrisch leitfähige Gräten zur Ausbildung einer Grätenform aufweist. Auf diese Weise kann die Zuverlässigkeit des Sensorelements weiter erhöht werden, da insbesondere elektrische Störungen vermieden werden können.

Optional ist es denkbar, dass das wenigstens eine Sensorelement zumindest zwei Sensorelemente aufweist, welche elektrisch voneinander getrennt sind und/oder separat voneinander mit einer Verarbeitungsvorrichtung verschaltet sind, um jeweils durch die Verarbeitungsvorrichtung elektrisch ausgewertet zu werden, und/oder um jeweils ein für die jeweilige kapazitive Erfassung spezifisches Erfassungssignal zu ermitteln und/oder zu verarbeiten, wobei vorzugsweise das Erfassungssignal die ortsabhängige Information trägt. Das Erfassungssignal kann z. B. zumindest teilweise durch einen Analog-Digital-Wandler der Verarbeitungsvorrichtung ermittelt werden, und anschließend beispielsweise durch einen Mikrocontroller oder Prozessor der Verarbeitungsvorrichtung ausgewertet werden. Auf diese Weise kann zuverlässig die kapazitive Erfassung durchgeführt werden.

In einer weiteren Möglichkeit kann vorgesehen sein, dass das wenigstens eine Sensorelement zumindest ein erstes und zweites Sensorelement aufweist, wobei eine elektronische Verarbeitungsvorrichtung mit den Sensorelementen verschaltet ist, um das zweite Sensorelement als Referenz zum ersten Sensorelement zur Bereitstellung der ortsabhängigen Information auszuwerten. Da unterschiedliche Aktivierungsmittel eine unterschiedliche Veränderung der Sensorkapazität bewirken können, können bei unterschiedlichen Aktivierungsmitteln und/oder gegebenenfalls auch durch weitere Einflüsse der Umgebung auch Aktivierungen an der gleichen Position des Sensorelements zu unterschiedlichen Amplituden beim Erfassungssignal führen. Zudem hat gegebenenfalls die Position aufgrund der ortsauflösenden Geometrie einen Einfluss auf die Amplitude. Um diesen Einfluss der Position auf die Amplitude zu extrahieren, ist die Nutzung einer Referenz vorteilhaft. So kann beispielsweise das zweite Sensorelement ebenfalls ein Erfassungssignal liefern, welches von dem Aktivierungsmittel und gegebenenfalls von weiteren Einflüssen aus der Umgebung abhängig ist. Ein Vergleich des Erfassungssignals, welches bei dem ersten Sensorelement ermittelt wird, mit dem Erfassungssignal, welches bei dem zweiten Sensorelement ermittelt wird, kann somit zur Bereitstellung der ortsabhängigen Information aus einem der Erfassungssignale führen.

Es kann möglich sein, dass bei der Nutzung eines einzigen Sensorelements zur Ortsbestimmung noch weitere Maßnahmen erforderlich sind. So ist es denkbar, dass je nach Aktivierungsmittel (Fingergröße oder dergleichen) unterschiedliche Signalamplituden (des Erfassungssignals) bei der Aktivierung (z. B. Annäherung) an der gleichen Position des Sensorelements auftreten. Um dieses Problem zu lösen, kann ein zweites Sensorelement (insbesondere als eine weitere zusätzliche Sensorelektrode) als Referenz dienen, welche insbesondere mit einem umgekehrten Richtungsvektor (d. h. hinsichtlich Ihrer Geometrie und/oder dem graduellen Verlauf komplementär zum ersten Sensorelement) angeordnet ist. Beide Sensorelemente können dabei die gleiche geometrische Form (z. B. die Keilform) aufweisen. Dies ermöglicht eine zweidimensionale Erfassung einer Aktivierung. Beispielsweise ist hierdurch eine Richtungsauflösung der Aktivierung von links nach rechts oder von unten nach oben bei dem Sensorelement möglich.

Es ist ferner denkbar, dass das wenigstens eine Sensorelement jeweils dazu ausgebildet ist, die Ortsauflösung für eine vorgegebene Richtung (insbesondere als ein Richtungsvektor) bereitzustellen. In anderen Worten können bei diesem Sensorelement anhand der ortsabhängigen Information in dieser vorgegebenen Richtung benachbarte Positionen unterschieden werden, jedoch gegebenenfalls nicht benachbarte Positionen in einer davon orthogonalen Richtung. In diesem Zusammenhang kann auch von einem Richtungsvektor für diese vorgegebene Richtung gesprochen werden, welcher beispielsweise in die Richtung zeigt, in welcher die Sensorfläche zunimmt und/oder die Signalamplituden des Erfassungssignals bei Aktivierung zunehmen. Dies ermöglicht es, z. B. bestimmte Aktivierungsmuster und/oder Gesten zu erfassen.

Des Weiteren kann vorgesehen sein, dass eine Verarbeitungsvorrichtung mit dem wenigstens einen Sensorelement verschaltet ist, um wiederholt ein Erfassungssignal des jeweiligen Sensorelements zu erfassen, und um eine zeitliche Veränderung des Erfassungssignals (bzw. vorangegangene Werte des Erfassungssignals) als Referenz zur Ermittlung der ortsabhängigen Information auszuwerten. Auf diese Weise kann z. B. eine eindimensionale Bewegung der Aktivierung (wie ein "Sliden") in einer Zeitebene erkannt werden. Beispielsweise kann bei einer zeitlich zunehmenden Signalamplitude des Erfassungssignals der Schluss gezogen werden, dass die Aktivierung eine Bewegung des Aktivierungsmittels umfasst, insbesondere in Richtung eines Bewegungsvektors des Sensorelements. Entsprechend dient hierbei die zeitliche Veränderung als Referenz, da nicht der Absolutwert sondern die zeitliche Differenz ausgewertet wird.

Unter einer Bewegung der Aktivierung wird insbesondere eine Veränderung der Position der Aktivierung, z. B. der Position eines angenäherten Aktivierungsmittels, verstanden. Die Aktivierung kann z. B. dadurch erkannt werden, dass eine Aktivierungsschwelle überschritten wird (z. B. durch eine Amplitude des Erfassungssignals, welche für eine Kapazitätsveränderung der Sensorkapazität spezifisch ist, und bei Aktivierung einen Grenzwert überschreitet). Dies erfolgt bspw. dann, wenn das Aktivierungsmittel (wie eine Hand) eine ausreichende Nähe zum Sensorelement hat. Eine Bewegung dieses Aktivierungsmittels bei gleichzeitiger Einhaltung der ausreichenden Nähe kann dann zur Bewegung der Aktivierung führen. Bevorzugt kann diese Bewegung der Aktivierung bei einem Sensorelement nur in Richtung des Bewegungsvektors des Sensorelements ausgewertet werden, wobei der Bewegungsvektor durch die ortsauflösende Geometrie dieses Sensorelements vorgegeben ist. Die Nutzung von mehr als einem benachbarten Sensorelement kann hingegen ggf. weitere Bewegungsvektoren hinzufügen (wenn z. B. zunächst die Aktivierung des ersten und dann des zweiten Sensorelements festgestellt wird, kann auf eine Bewegung vom ersten zum zweiten Sensorelement geschlossen werden).

Gemäß einer vorteilhaften Weiterbildung der Erfindung kann vorgesehen sein, dass das wenigstens eine Sensorelement zumindest ein oder zwei Sensorelemente aufweist, welche jeweils zur wiederholt durchgeführten Ladungsübertragung mit einer Verarbeitungsvorrichtung elektrisch verschaltet sind, um anhand der Ladungsübertragung eine Veränderung einer jeweils durch das Sensorelement bereitgestellten veränderlichen Kapazität auszuwerten, welche für eine Annäherung an das Sensorelement spezifisch ist. Auf diese Weise ist eine zuverlässige kapazitive Erfassung von Aktivierungshandlungen, wie einer Annäherung und/oder Berührung, möglich.

Es kann weiter möglich sein, dass das wenigstens eine Sensorelement zumindest zwei Sensorelemente aufweist, welche geometrisch identisch ausgebildet sind. Dies ermöglicht es, die Kosten für die Herstellung des Sensorelements zu reduzieren.

In einer weiteren Möglichkeit kann vorgesehen sein, dass eine Verarbeitungsvorrichtung mit dem wenigstens einen Sensorelement verschaltet ist, um anhand einer Auswertung der ortsabhängigen Information Störeinflüsse, vorzugsweise Umwelteinflüsse, insbesondere Regen, bei der kapazitiven Erfassung zu detektieren. Dies ist beispielsweise dadurch möglich, dass die Bewegung der Aktivierung des Sensorelements ausgewertet wird. Wenn beispielsweise zeitabhängig zunächst ein (hinsichtlich einer Fahrzeughochachse) oberes Sensorelement an einer bestimmten Position (insbesondere entlang der Fahrzeuglängsachse) aktiviert wird und anschließend an der gleichen Position das darunter liegende Sensorelement aktiviert wird, kann auf die Aktivierung durch einen Regentropfen oder dergleichen geschlossen werden.

Ebenfalls Gegenstand der Erfindung ist eine Fahrzeugkomponente, insbesondere ein Türgriff oder Stoßfänger oder Schweller oder Emblem, mit einer (insbesondere erfindungsgemäßen) Sensoranordnung für eine kapazitive Erfassung bei der Fahrzeugkomponente.

Es kann vorgesehen sein, dass die Sensoranordnung und/oder eine erfindungsgemäße Sensoranordnung wenigstens die nachfolgende Komponente aufweist:
- wenigstens ein elektrisch leitfähiges Sensorelement, um jeweils die kapazitive Erfassung für eine Umgebung des Sensorelements bereitzustellen.

Hierbei ist vorgesehen, dass das Sensorelement jeweils mit einer ortsauflösenden Geometrie ausgebildet ist, um eine ortsabhängige Information bei der Erfassung zu erhalten. Damit bringt die erfindungsgemäße Fahrzeugkomponente die gleichen Vorteile mit sich, wie sie ausführlich mit Bezug auf eine erfindungsgemäße Sensoranordnung beschrieben worden ist.

Es ist ferner denkbar, dass die Sensoranordnung in einem Gehäuse der Fahrzeugkomponente, z. B. in einem Türgriffgehäuse, montiert ist. Dabei kann die Sensoranordnung so ausgerichtet sein, dass ein Richtungsvektor (d. h. die Richtung der Ortsauflösung) parallel zu einer Fahrzeuglängsachse (z. B. im Falle des Türgriffs) oder parallel zur Fahrzeugquerachse (z. B. im Falle des Stoßfängers) ausgerichtet ist. Auf diese Weise können benachbarte Positionen der Aktivierung bei dem jeweiligen Sensorelement in Richtung des Richtungsvektors unterschieden werden, um somit komfortable Möglichkeiten zur Aktivierung von Fahrzeugfunktionen bereitzustellen.

Ebenfalls Gegenstand der Erfindung ist ein Verfahren zur Auswertung einer (insbesondere erfindungsgemäßen) Sensoranordnung für eine kapazitive Erfassung bei einem Fahrzeug, insbesondere für einen Türgriff oder ein Emblem oder einen Schweller oder einen Stoßfänger des Fahrzeuges. Hierbei ist insbesondere vorgesehen, dass die Sensoranordnung wenigstens ein elektrisch leitfähiges Sensorelement aufweist, um jeweils die kapazitive Erfassung für eine Umgebung des Sensorelements bereitzustellen, wobei bevorzugt das Sensorelement jeweils mit einer ortsauflösenden Geometrie ausgebildet ist, um insbesondere eine ortsabhängige Information (insbesondere durch eine ortsabhängige Sensitivität des Sensorelements) bei der Erfassung zu erhalten.

Dabei können zur Auswertung des jeweiligen Sensorelements die nachfolgenden Schritte durchgeführt werden, insbesondere durch eine elektronische Verarbeitungsvorrichtung, vorzugsweise nacheinander in der angegebenen oder in beliebiger Reihenfolge:
- Erfassen eines Erfassungssignals durch Initiierung wenigstens einer Ladungsübertragung bei dem Sensorelement, bei welcher vorzugsweise Ladungen vom Sensorelement zur Verarbeitungsvorrichtung übertragen werden, um eine veränderliche Kapazität auszuwerten, welche durch das Sensorelement bereitgestellt wird,
- Durchführen eines Vergleichs (insbesondere einer Amplitude des Erfassungssignals) mit einer Aktivierungsschwelle bei dem Erfassungssignal, wobei vorzugsweise die Aktivierungsschwelle ein Grenzwert für eine Amplitude des Erfassungssignals, insbesondere einer Ladungsmenge der übertragenen Ladung und/oder einer davon abhängigen elektrischen Spannung oder sonstigen Parameters, ist,
- Detektieren einer Aktivierung des Sensorelements, wenn die Aktivierungsschwelle bei dem Vergleich (z. B. durch die Amplitude) überschritten wird, wobei die Aktivierung bevorzugt ortsaufgelöst anhand einer Auswertung der Amplitude erfasst wird.

Damit bringt das erfindungsgemäße Verfahren die gleichen Vorteile mit sich, wie sie ausführlich mit Bezug auf eine erfindungsgemäße Sensoranordnung und/oder Fahrzeugkomponente beschrieben worden sind. Zudem kann das Verfahren geeignet sein, eine erfindungsgemäße Sensoranordnung und/oder Fahrzeugkomponente zu betreiben.

Vor und nach der Ladungsübertragung kann das Sensorelement ggf. aufgeladen werden, sodass Lade- und Entladezyklen im Wechsel erfolgen.

Des Weiteren ist es denkbar, dass das wenigstens eine Sensorelement zumindest ein erstes und zweites Sensorelement aufweist, für welche jeweils die Aktivierung bei der jeweiligen Auswertung detektiert wird, wobei gemäß einem weiteren Schritt die zeitlich überlappenden und/oder aufeinanderfolgenden Aktivierungen unterschiedlicher Sensorelemente miteinander verglichen werden, um eine Aktivierungskombination dieser Aktivierungen zu detektieren, um für unterschiedliche Aktivierungskombinationen unterschiedliche Funktionen des Fahrzeuges zu aktivieren. Dies hat den Vorteil, dass durch zwei Sensorelemente eine Vielzahl von Aktivierungsmöglichkeiten bereitgestellt werden können.

Es ist ferner denkbar, dass das wenigstens eine Sensorelement zumindest ein erstes und zweites Sensorelement aufweist, und/oder zusätzlich ein Sensormittel benachbart zum ersten und/oder zweiten Sensorelement an einer Leiterplatte der Sensoranordnung angeordnet ist, um zur Detektion einer Aktivierungshandlung verschiedene Aktivierungskombinationen der oder des Sensorelements und/oder des Sensormittels auszuwerten. Beispielsweise kann die gleichzeitige Aktivierung des ersten und zweiten Sensorelements eine andere Funktion des Fahrzeuges aktivieren als die zeitgleiche Aktivierung des ersten Sensorelements und des Sensormittels oder des Sensormittels alleine. Beispielsweise ist eine zeitliche Aktivierung zunächst des ersten Sensorelements und dann des zweiten Sensorelements einem Entriegeln und/oder Öffnen des Fahrzeuges als Fahrzeugfunktion zugeordnet, wohingegen alternativ oder zusätzlich die Aktivierung des Sensormittels einem Entriegeln des Fahrzeuges als Funktion zugeordnet sein kann. Auch ist es denkbar, dass eine anderweitige Aktivierungskombination dem Entriegeln und/oder Öffnen des Fahrzeuges als Fahrzeugfunktion zugeordnet ist, wie z. B. das Aktivieren mit einer bestimmten Bewegungsrichtung an einem der Sensorelemente und oder eine gleichzeitige Aktivierung des ersten und zweiten Sensorelements.

Es ist ferner denkbar, dass zur Auswertung verschiedener Aktivierungskombinationen die verschiedenen Aktivierungskombinationen als eine Matrix in einer Verarbeitungsvorrichtung nicht flüchtig gespeichert sind. Gemäß dieser Matrix kann z. B. eine Zuordnung der Aktivierungskombinationen zu den dadurch aktivierbaren Funktionen des Fahrzeuges erfolgen. Es ist ferner auch denkbar, dass diese Matrix digital und/oder fest z. B. durch eine anwendungsspezifische integrierte Schaltung bei der Verarbeitungsvorrichtung gespeichert ist.

Es ist ferner denkbar, dass die ortsabhängige Information dadurch erhalten (bestimmt) wird, dass bei (positiver) Detektion der Aktivierung eine Amplitude des Erfassungssignals ausgewertet wird, vorzugsweise zeitabhängig (z. B. anhand der Differenz der Amplitude bei zeitlich nachfolgenden Aktivierungen wenigstens eines Sensorelements) und/oder durch einen Vergleich des Erfassungssignals unterschiedlicher der Sensorelemente, z. B. der Amplitude eines ersten Erfassungssignals des ersten Sensorelements mit der Amplitude eines zweiten Erfassungssignals des zweiten Sensorelements (bspw. als Referenz), um ein für den Ort der Aktivierung am Sensorelement charakteristisches Merkmal zu identifizieren (wie z. B. eine zu- oder abnehmende Amplitude zur Identifikation einer Bewegung der Aktivierung, d. h. der Aktivierungsposition, am Sensorelement), um wenigstens eine Funktion des Fahrzeuges in Abhängigkeit von dem Ort und/oder eine Bewegung der Aktivierung zu aktivieren. Auf diese Weise können durch die ortsaufgelöste Aktivierung unter Nutzung der ortsabhängigen Information weitere Positionen der Aktivierung unterschieden werden, um ggf. weitere Aktivierungskombinationen bereitzustellen.

Ebenfalls Gegenstand der Erfindung ist ein Computerprogramm, insbesondere Computerprogrammprodukt. Hierbei ist vorgesehen, dass das Computerprogramm Befehle umfasst, die bei der Ausführung des Computerprogramms durch eine Verarbeitungsvorrichtung wie einen Computer und/oder eine Elektronikanordnung diese veranlassen, die Schritte eines erfindungsgemäßen Verfahrens auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Weitere Vorteile, Merkmale und Einzelheiten der Erfindung ergeben sich aus der nachfolgenden Beschreibung, in der unter Bezugnahme auf die Zeichnungen

Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen dabei jeweils schematisch:
- Fig. 1: Eine schematische Seitenansicht eines Fahrzeuges,
- Fig. 2 - 6: schematische Draufsichten auf eine erfindungsgemäße Sensoranordnung,
- Fig. 7: eine perspektivische schematische Ansicht auf eine erfindungsgemäße Sensoranordnung,
- Fig. 8: eine schematische Darstellung zur Visualisierung eines erfindungsgemäßen Verfahrens.

In den nachfolgenden Figuren werden für die gleichen technischen Merkmale auch von unterschiedlichen Ausführungsbeispielen die identischen Bezugszeichen verwendet.

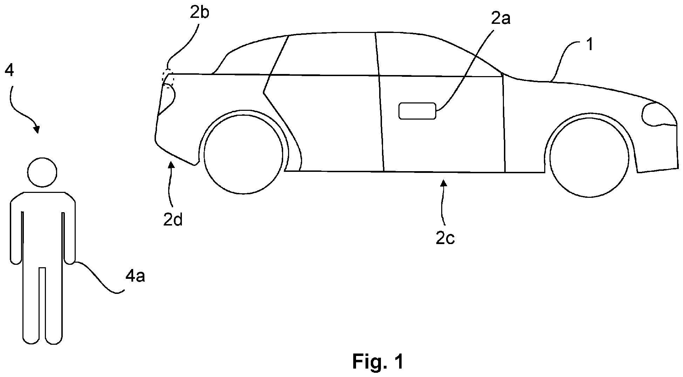

In Figur 1 ist schematisch eine Seitenansicht eines Fahrzeuges 1 gezeigt, welches mehrere Fahrzeugkomponenten 2 aufweisen kann. Beispielhaft gezeigt ist ein Türgriff 2a in der Form eines Außentürgriffs 2a, ein Emblem 2b, ein Schweller 2c sowie ein Stoßfänger 2d. Ein oder mehrere dieser Fahrzeugkomponenten 2 können dabei als erfindungsgemäße Fahrzeugkomponente 2 ausgebildet sein, und ggf. auch eine erfindungsgemäße Sensoranordnung 10 aufweisen. Auf diese Weise kann es ermöglicht werden, dass eine Aktivierungshandlung wie eine Annäherung und/oder Berührung und/oder Geste eines Aktivierungsmittels 4a wie eine Hand eines Bedieners 4 durch die Sensoranordnung 10 detektiert wird. Die erfolgreiche Detektion kann dazu führen, dass eine (ggf. sicherheitsrelevante) Funktion des Fahrzeuges ausgelöst wird. Bspw. kann die Detektion der Annäherung des Aktivierungsmittels 4a an den Stoßfänger 2d mit der erfindungsgemäßen Sensoranordnung 10 dazu führen, dass die Heckklappe geöffnet wird. Alternativ oder zusätzlich kann die Detektion der Annäherung des Aktivierungsmittels 4a an den Türgriff 2a mit der erfindungsgemäßen Sensoranordnung 10 dazu führen, dass das Fahrzeug 1 entriegelt wird. Erfindungsgemäß kann die Detektion nur dann erfolgen, wenn neben der Annäherung (d. h. auch Berührung) weitere Voraussetzungen erfüllt sind. Zum Beispiel muss die Annäherung an einer bestimmten Position und/oder mit einer bestimmten Bewegungsrichtung und/oder gemäß einer bestimmten Aktivierungskombination der Sensoranordnung 10 erfolgt sein, um die Detektion zu bewirken. Hierzu kann die ortsauflösende Eigenschaft der Sensoranordnung 10 genutzt werden.

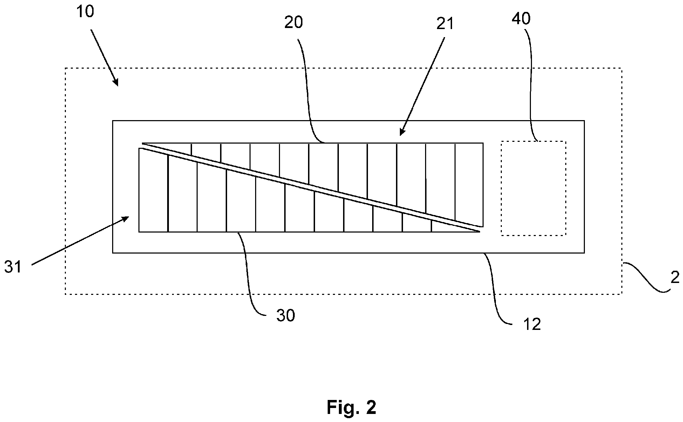

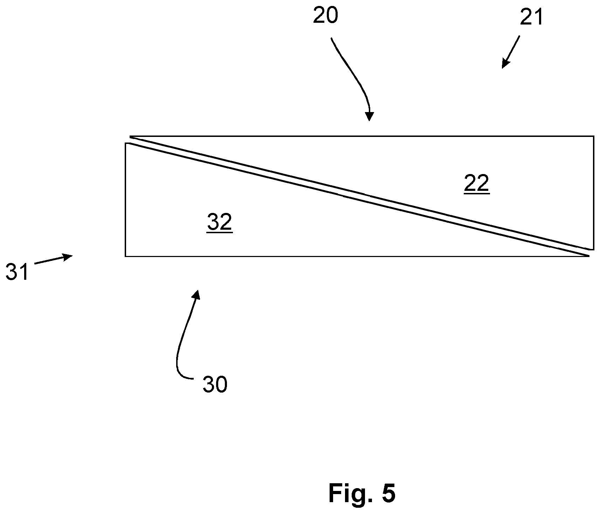

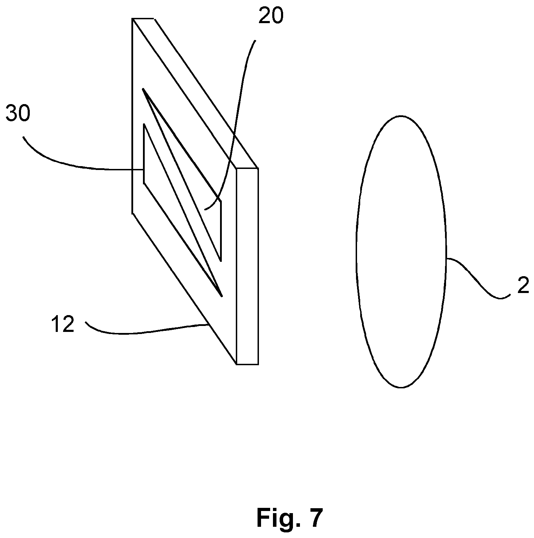

In Figur 2 bis 7 sind beispielhafte Varianten einer erfindungsgemäßen Sensoranordnung 10 gezeigt. Die erfindungsgemäße Sensoranordnung 10 kann zur kapazitiven Erfassung bei einem Fahrzeug 1, insbesondere für einen Türgriff 2a oder ein Emblem 2b oder einen Schweller 2c oder einen Stoßfänger 2d des Fahrzeuges 1, ausgeführt sein. Hierzu kann die Sensoranordnung 10 wenigstens ein elektrisch leitfähiges Sensorelement 20, 30 aufweisen, um jeweils die kapazitive Erfassung für eine Umgebung des Sensorelements 20, 30 bereitzustellen. In den gezeigten Beispielen weist das Sensorelement 20, 30 jeweils eine ortsauflösende Geometrie 21 auf, um eine ortsabhängige Information bei der Erfassung zu erhalten. Diese ortsabhängige Information ist bspw. die Information, dass eine Annäherung an einer bestimmten Position und/oder mit einer bestimmten Bewegungsrichtung und/oder gemäß einer bestimmten Aktivierungskombination an der Sensoranordnung 10 erfolgt ist.

Ferner ist in den Figuren gezeigt, dass das Sensorelement 20, 30 jeweils als wenigstens eine elektrisch leitfähige Fläche an einer Leiterplatte 12 ausgebildet ist, um eine veränderliche Kapazität für die kapazitive Erfassung bereitzustellen, wobei die ortsauflösende Geometrie 21 als eine geometrische Anpassung dieser Fläche ausgebildet ist, um die Veränderlichkeit der Kapazität ortsabhängig anzupassen.

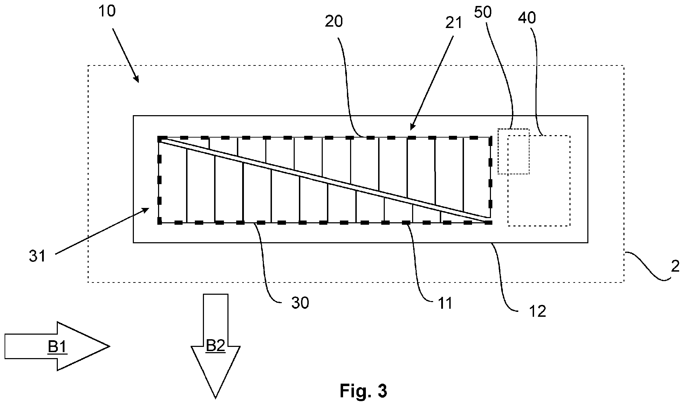

Gemäß den Figuren 2 bis 7 ist das Sensorelement 20, 30 jeweils insgesamt als eine dreieckige und keilförmige Sensorelektrode 20, 30 ausgebildet, auch wenn es ggf. mehrere Segmente 22 mit davon abweichender (z. B. rechteckiger) Form aufweist. Dabei ist ein erstes Sensorelement 20 des wenigstens einen Sensorelements 20, 30 derart benachbart zu einem zweiten Sensorelement 30 des wenigstens einen Sensorelements 20, 30 angeordnet, dass das erste und zweite Sensorelement 20, 30 gemeinsam einen rechteckigen Erfassungsbereich 11 bereitstellen, wie in Figur 3 durch eine gestrichelte Linie verdeutlicht wird.

Es ist erkennbar, dass die ortsauflösende Geometrie 21 als eine Asymmetrie einer aktiven Sensorfläche des jeweiligen Sensorelements 20 ausgebildet ist, um an verschiedenen Positionen der Sensorfläche eine unterschiedliche und graduell ansteigende Veränderlichkeit einer Kapazität bei dem Sensorelement 20 bereitzustellen, wobei die unterschiedliche Veränderlichkeit für die ortsabhängige Information spezifisch ist. Entsprechend kann das Sensorelement 20 jeweils ortsabhängig mit unterschiedlicher, vorzugsweise graduell ansteigender und/oder vorgegebener, Sensitivität ausgebildet sein, um anhand der unterschiedlichen Sensitivität die ortsabhängige Information bereitzustellen.

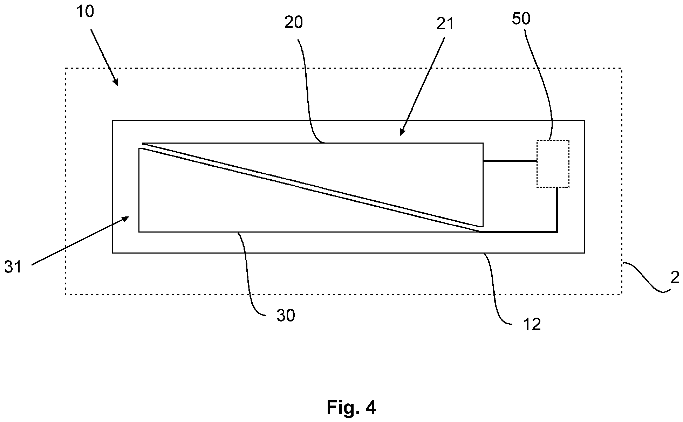

Gemäß Figur 4 ist das wenigstens eine Sensorelement 20 jeweils mit einer Verarbeitungsvorrichtung 50 verschaltet, um die ortsabhängige Information durch eine elektrische Auswertung des jeweiligen Sensorelements 20 zu ermitteln, insbesondere durch eine Auswertung einer veränderlichen Kapazität, um anhand der ortsabhängigen Information eine Geste und/oder eine Aktivierungskombination zu detektieren und/oder eine sicherheitsrelevante Funktion bei dem Fahrzeug zu aktivieren. Zur Verbesserung der kapazitiven Erfassung kann das wenigstens eine Sensorelement 20, 30 ein erstes 20 und zweites 30 Sensorelement aufweisen, welche gemäß z. B. Figur 2 bis 7 unmittelbar benachbart zueinander an einer Leiterplatte 12 angeordnet sind, um durch beide Sensorelemente 20, 30 gemeinsam synergetisch die kapazitive Erfassung bereitzustellen, wobei die Sensorelemente 20, 30 hierzu geometrisch komplementär zueinander angeordnet sind.

Gemäß Figur 2 bis 5 ist eines bzw. sind wenigstens zwei des wenigstens einen Sensorelements 20, 30 jeweils vollflächig als eine elektrisch leitfähige und insbesondere potentialgleiche Fläche ausgebildet.

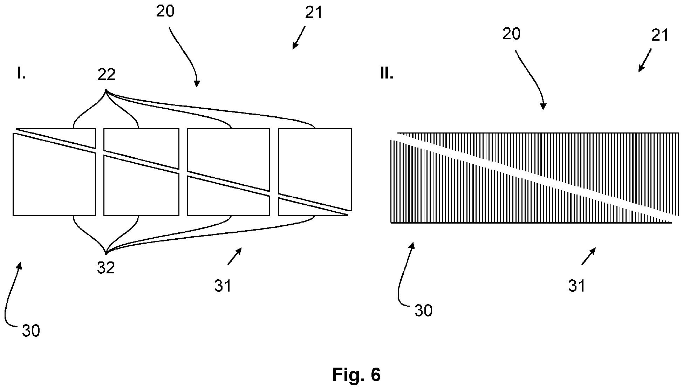

Gemäß Figur 6 ist bei I. dargestellt, dass eines bzw. wenigstens zwei des wenigstens einen Sensorelements 20, 30 jeweils mehrere Segmente 22, 32 zur Ausbildung eine Segmentform I. aufweist, welche als beabstandete Leiterflächen ausgebildet sind, und elektrisch miteinander verbunden und/oder potentialgleich sind. Bei II. ist hingegen gezeigt, dass eines bzw. wenigstens zwei des wenigstens einen Sensorelements 20, 30 jeweils elektrisch leitfähige Gräten zur Ausbildung einer Grätenform II. aufweisen.

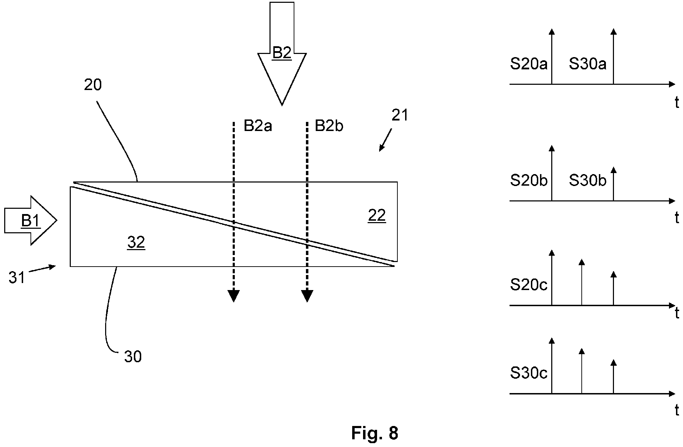

In Figur 3 und 8 ist verdeutlicht, dass das wenigstens eine Sensorelement 20 jeweils dazu ausgebildet ist, die Ortsauflösung für eine vorgegebene Richtung B1, B2 bereitzustellen. Dabei kann die Verarbeitungsvorrichtung 50 mit dem wenigstens einen Sensorelement 20 verschaltet sein, um wiederholt ein Erfassungssignal des jeweiligen Sensorelements 20 zu erfassen, und um eine zeitliche Veränderung des Erfassungssignals als Referenz zur Ermittlung der ortsabhängigen Information auszuwerten. Dies ermöglicht es z. B., durch die Verarbeitungsvorrichtung 50 anhand einer Auswertung der ortsabhängigen Information Störeinflüsse, vorzugsweise Umwelteinflüsse, insbesondere Regen, bei der kapazitiven Erfassung zu detektieren.

Anhand Figur 8 wird nachfolgend ein erfindungsgemäßes Verfahren veranschaulicht. Zur Auswertung des jeweiligen Sensorelements 20 können dabei die nachfolgenden Schritte durchgeführt werden, insbesondere durch die elektronische Verarbeitungsvorrichtung 50:
- Erfassen eines Erfassungssignals durch Initiierung wenigstens einer Ladungsübertragung bei dem Sensorelement 20, 30,
- Durchführen eines Vergleichs mit einer Aktivierungsschwelle bei dem Erfassungssignal,
- Detektieren einer Aktivierung des Sensorelements 20, 30, wenn die Aktivierungsschwelle bei dem Vergleich überschritten wird.

Dabei kann das wenigstens eine Sensorelement 20, 30 zumindest ein erstes und zweites Sensorelement 20, 30 aufweisen, für welche jeweils die Aktivierung bei der jeweiligen Auswertung detektiert wird, wobei gemäß einem weiteren Schritt die zeitlich überlappenden und/oder aufeinanderfolgenden Aktivierungen unterschiedlicher Sensorelemente 20, 30 miteinander verglichen werden, um eine Aktivierungskombination dieser Aktivierungen zu detektieren, um für unterschiedliche Aktivierungskombinationen unterschiedliche Funktionen des Fahrzeuges 1 zu aktivieren.

In Fig. 8 ist ferner die Auswertung der Sensoranordnung 10 mittels verschiedener Aktivierungskombinationen gezeigt. Diese Aktivierungskombinationen können z. B. gleichzeitige und/oder zeitlich aufeinanderfolgende Aktivierungen eines ersten Sensorelements 20 und/oder eines zweiten Sensorelements 30 und/oder eines Sensormittels 40 (als zusätzliche Sensorelektrode) betreffen. Beispielhaft ist eine erste Betätigung B2a und eine zweite Betätigung B2b jeweils in eine zweite Bewegungsrichtung B2 gezeigt. Die jeweilige Betätigung B2a, B2b kann z. B. eine Aktivierung sein, bei welcher ein Aktivierungsmittel sich an das erste Sensorelement 20 annähert und anschließend in Richtung B2 zum zweiten Sensorelement 30 bewegt wird. Um die Auswertung einer solchen Aktivierungskombination zu verdeutlichen, ist rechts in Fig. 8 ein beispielhafter erster Signalausschlag S20a für ein erstes Sensorelement 20 und ein beispielhafter erster Signalausschlag S30a für ein zweites Sensorelement 30 über die Zeit t dargestellt. Dabei ist erkennbar, dass der erste Signalausschlag S20a bei der ersten Betätigung B2a etwa gleichgroß ist zum nachfolgenden ersten Signalausschlag S30a, wenn das Aktivierungsmittel beim zweiten Sensorelement 30 angelangt ist. Dies hängt damit zusammen, dass das erste Sensorelement 20 und das zweite Sensorelement 30 an der Position der ersten Betätigung B2a in Richtung B2 die gleiche Ausdehnung aufweist. Hingegen kann bei einer dazu versetzten zweiten Betätigung B2b ein zweiter Signalausschlag S20b für das erste Sensorelement 20 größer ausfallen als der darauffolgende zweite Signalausschlag S30b für das zweite Sensorelement 30. In diesem Fall hat an der Position der zweiten Betätigung B2b in Richtung B2 das zweite Sensorelement 30 eine geringere Ausdehnung als das erste Sensorelement 20.

Neben dieser beschriebenen zeitlichen Aktivierung zunächst des ersten und dann des zweiten Sensorelements ist alternativ oder zusätzlich eine gleichzeitige Aktivierung des ersten und zweiten Sensorelements denkbar, welches dann ebenfalls eine Aktivierungskombination darstellen kann. Hierzu müssen lediglich die Signalausschläge, wie beschrieben ausgewertet, jedoch gleichzeitig erfasst werden.

Auch ist es denkbar, als Aktivierungskombination einen Aktivierungsverlauf für ein einzelnes Sensorelement 20, 30 zu umfassen. Beispielhaft ist ein erster Signalverlauf S20c für ein erstes Sensorelement 20 dargestellt, bei welchem sich das Aktivierungsmittel nach der Annäherung an das Sensorelement 20 in eine Richtung entgegengesetzt zur Richtung B1 bewegt. Außerdem ist ein zweiter Signalverlauf S30c für das zweite Sensorelement 30 gezeigt, bei welchem das Aktivierungsmittel sich gemäß einer weiteren Aktivierungskombination nach der Annäherung an das zweite Sensorelement 30 in Richtung B1 bewegt. Die jeweils beschriebenen Aktivierungskombinationen können z. B. zur Entriegelung und/oder Öffnung des Fahrzeuges als Fahrzeugfunktion ausgeführt sein, und eine Aktivierung eines Sensormittels 40 - wie in Fig. 3 gezeigt - z. B. zur Aktivierung einer Verriegelung des Fahrzeuges als weitere Fahrzeugfunktion ausgeführt sein.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Fahrzeugkomponente

- 2d: Stoßfänger
- 2a: Türgriff
- 2b: Emblem
- 2c: Schweller
- 4: Bediener

- 4a: Aktivierungsmittel, Hand

- 10: Sensoranordnung
- 11: Erfassungsbereich
- 12: Leiterplatte

- 20: Sensorelement, Sensorelektrode, erstes Sensorelement
- 21: ortsauflösende Geometrie, geometrische Anpassung
- 22: Segmente, Sensorteilelement des ersten Sensorelements

- 30: zweites Sensorelement
- 31: ortsauflösende Geometrie des weiteren Sensorelements
- 32: Segmente, Sensorteilelement des zweiten Sensorelements

- 40: Sensormittel, zusätzliche Sensorelektrode

- 50: Verarbeitungsvorrichtung

- t: Zeit
- B1: erste Bewegungsrichtung
- B2: zweite Bewegungsrichtung
- B2a: erste Betätigung
- B2b: zweite Betätigung
- I.: Segmentform
- II.: Grätenform
- S20a: erster Signalausschlag für erstes Sensorelement
- S20b: zweiter Signalausschlag für erstes Sensorelement
- S20c: Signalverlauf für erstes Sensorelement
- S30a: erster Signalausschlag für zweites Sensorelement
- S30b: zweiter Signalausschlag für zweites Sensorelement
- S30c: Signalverlauf für zweites Sensorelement

## Patentansprüche

1. Sensoranordnung (10) für eine kapazitive Erfassung bei einem Fahrzeug (1), insbesondere für einen Türgriff (2a) oder ein Emblem (2b) oder einen Schweller (2c) oder einen Stoßfänger (2d) des Fahrzeuges (1),
aufweisend:
- wenigstens ein elektrisch leitfähiges Sensorelement (20, 30), um jeweils die kapazitive Erfassung für eine Umgebung des Sensorelements (20, 30) bereitzustellen,
wobei das Sensorelement (20, 30) jeweils mit einer ortsauflösenden Geometrie (21) ausgebildet ist, um eine ortsabhängige Information bei der Erfassung zu erhalten,
wobei das Sensorelement (20, 30) jeweils als eine keilförmige Sensorelektrode (20, 30) ausgebildet ist, und wobei ein erstes Sensorelement (20) des wenigstens einen Sensorelements (20, 30) derart benachbart zu einem zweiten Sensorelement (30) des wenigstens einen Sensorelements (20, 30) angeordnet ist, dass das erste und zweite Sensorelement (20, 30) gemeinsam einen rechteckigen Erfassungsbereich (11) bereitstellen, wobei eines oder wenigstens zwei des wenigstens einen Sensorelements (20, 30) jeweils elektrisch leitfähige Gräten zur Ausbildung einer Grätenform (II.) aufweist,
wobei das zweite Sensorelement (30) als Referenz dient und mit einem umgekehrten Richtungsvektor hinsichtlich des graduellen Verlaufs komplementär zum ersten Sensorelement (20) angeordnet ist, wobei beide Sensorelemente (20, 30) die gleiche Keilform aufweisen.

2. Sensoranordnung (10) nach Anspruch 1,
**wobei** das Sensorelement (20, 30) jeweils als wenigstens eine elektrisch leitfähige Fläche, insbesondere an einer Leiterplatte (12), ausgebildet ist, um eine veränderliche Kapazität für die kapazitive Erfassung bereitzustellen, wobei die ortsauflösende Geometrie (21) als eine geometrische Anpassung dieser Fläche ausgebildet ist, um die Veränderlichkeit der Kapazität ortsabhängig anzupassen.

3. Sensoranordnung (10) nach einem der vorhergehenden Ansprüche,
**wobei** die ortsauflösende Geometrie (21) als eine Asymmetrie einer aktiven Sensorfläche des jeweiligen Sensorelements (20) ausgebildet ist, um an verschiedenen Positionen der Sensorfläche eine unterschiedliche, vorzugsweise graduell ansteigende, Veränderlichkeit einer Kapazität bei dem Sensorelement (20) bereitzustellen, wobei die unterschiedliche Veränderlichkeit für die ortsabhängige Information spezifisch ist.

4. Sensoranordnung (10) nach einem der vorhergehenden Ansprüche,
**wobei** das Sensorelement (20) jeweils ortsabhängig mit unterschiedlicher, vorzugsweise graduell ansteigender und/oder vorgegebener, Sensitivität ausgebildet ist, um anhand der unterschiedlichen Sensitivität die ortsabhängige Information bereitzustellen.

5. Sensoranordnung (10) nach einem der vorhergehenden Ansprüche,
**wobei** das wenigstens eine Sensorelement (20) jeweils mit einer Verarbeitungsvorrichtung (50) verschaltet ist, um die ortsabhängige Information durch eine elektrische Auswertung des jeweiligen Sensorelements (20) zu ermitteln, insbesondere durch eine Auswertung einer veränderlichen Kapazität, um vorzugsweise anhand der ortsabhängigen Information eine Geste und/oder eine Aktivierungskombination zu detektieren und/oder eine sicherheitsrelevante Funktion bei dem Fahrzeug zu aktivieren
und dass das wenigstens eine Sensorelement (20, 30) ein erstes (20) und zweites (30) Sensorelement aufweist, welche unmittelbar benachbart zueinander an einer Leiterplatte (12) angeordnet sind, um durch beide Sensorelemente (20, 30) gemeinsam synergetisch die kapazitive Erfassung bereitzustellen, wobei die Sensorelemente (20, 30) hierzu vorzugsweise geometrisch komplementär zueinander angeordnet sind.

6. Sensoranordnung (10) nach einem der vorhergehenden Ansprüche,
**wobei** das wenigstens eine Sensorelement (20, 30) zumindest zwei Sensorelemente (20, 30) aufweist, welche elektrisch voneinander getrennt sind und/oder separat voneinander mit einer Verarbeitungsvorrichtung (50) verschaltet sind, um jeweils durch die Verarbeitungsvorrichtung (50) elektrisch ausgewertet zu werden, um jeweils ein für die jeweilige kapazitive Erfassung spezifisches Erfassungssignal zu ermitteln und/oder zu verarbeiten, wobei vorzugsweise das Erfassungssignal die ortsabhängige Information trägt
und dass das wenigstens eine Sensorelement (20, 30) zumindest ein erstes und zweites Sensorelement (20, 30) aufweist, wobei eine elektronische Verarbeitungsvorrichtung (50) mit den Sensorelementen (20, 30) verschaltet ist, um das zweite Sensorelement (30) als Referenz zum ersten Sensorelement (20) zur Bereitstellung der ortsabhängigen Information auszuwerten
und/oder dass das wenigstens eine Sensorelement (20) jeweils dazu ausgebildet ist, die Ortsauflösung für eine vorgegebene Richtung (B1, B2) bereitzustellen.

7. Sensoranordnung (10) nach einem der vorhergehenden Ansprüche,
**wobei** eine Verarbeitungsvorrichtung (50) mit dem wenigstens einen Sensorelement (20) verschaltet ist, um wiederholt ein Erfassungssignal des jeweiligen Sensorelements (20) zu erfassen, und um eine zeitliche Veränderung des Erfassungssignals zur Ermittlung der ortsabhängigen Information auszuwerten
und dass das wenigstens eine Sensorelement (20, 30) zumindest ein oder zwei Sensorelemente (20, 30) aufweist, welche jeweils zur wiederholt durchgeführten Ladungsübertragung mit einer Verarbeitungsvorrichtung (50) elektrisch verschaltet sind, um anhand der Ladungsübertragung eine Veränderung einer jeweils durch das Sensorelement (20, 30) bereitgestellten veränderlichen Kapazität auszuwerten, welche für eine Annäherung an das Sensorelement (20, 30) spezifisch ist
und dass das wenigstens eine Sensorelement (20, 30) zumindest zwei Sensorelemente (20, 30) aufweist, welche geometrisch identisch ausgebildet sind
und/oder dass eine Verarbeitungsvorrichtung (50) mit dem wenigstens einen Sensorelement (20) verschaltet ist, um anhand einer Auswertung der ortsabhängigen Information Störeinflüsse, vorzugsweise Umwelteinflüsse, insbesondere Regen, bei der kapazitiven Erfassung zu detektieren.

8. Fahrzeugkomponente (2), insbesondere Türgriff (2a) oder Stoßfänger (2d), mit einer Sensoranordnung (10) für eine kapazitive Erfassung bei der Fahrzeugkomponente (2), aufweisend:
- wenigstens ein elektrisch leitfähiges Sensorelement (20, 30), um jeweils die kapazitive Erfassung für eine Umgebung des Sensorelements (20, 30) bereitzustellen,
wobei das Sensorelement (20, 30) jeweils mit einer ortsauflösenden Geometrie (21) ausgebildet ist, um eine ortsabhängige Information bei der Erfassung zu erhalten,
wobei die Sensoranordnung (10) nach einem der vorhergehenden Ansprüche ausgebildet ist.

9. Verfahren zur Auswertung einer Sensoranordnung (10) für eine kapazitive Erfassung bei einem Fahrzeug (1), insbesondere für einen Türgriff (2a) oder ein Emblem (2b) oder einen Schweller (2c) oder einen Stoßfänger (2d) des Fahrzeuges (1), wobei
die Sensoranordnung (10) wenigstens ein elektrisch leitfähiges Sensorelement (20, 30) aufweist, um jeweils die kapazitive Erfassung für eine Umgebung des Sensorelements (20, 30) bereitzustellen, wobei
das Sensorelement (20, 30) jeweils mit einer ortsauflösenden Geometrie (21) ausgebildet ist, um eine ortsabhängige Information bei der Erfassung zu erhalten, wobei zur Auswertung des jeweiligen Sensorelements (20, 30) die nachfolgenden Schritte durchgeführt werden, insbesondere durch eine elektronische Verarbeitungsvorrichtung (50):
- Erfassen eines Erfassungssignals durch Initiierung wenigstens einer Ladungsübertragung bei dem Sensorelement (20, 30),
- Durchführen eines Vergleichs mit einer Aktivierungsschwelle bei dem Erfassungssignal,
- Detektieren einer Aktivierung des Sensorelements (20, 30), wenn die Aktivierungsschwelle bei dem Vergleich überschritten wird,
wobei die Sensoranordnung (10) nach einem der vorhergehenden Ansprüche ausgebildet ist.

10. Verfahren nach einem der vorhergehenden Ansprüche,
**wobei** das wenigstens eine Sensorelement (20, 30) zumindest ein erstes und zweites Sensorelement (20, 30) aufweist, für welche jeweils die Aktivierung bei der jeweiligen Auswertung detektiert wird, wobei gemäß einem weiteren Schritt die zeitlich überlappenden und/oder aufeinanderfolgenden Aktivierungen unterschiedlicher Sensorelemente (20, 30) miteinander verglichen werden, um eine Aktivierungskombination dieser Aktivierungen zu detektieren, um für unterschiedliche Aktivierungskombinationen unterschiedliche Funktionen des Fahrzeuges (1) zu aktivieren.

11. Verfahren nach einem der vorhergehenden Ansprüche,
**wobei** die ortsabhängige Information dadurch erhalten wird, dass bei Detektion der Aktivierung eine Amplitude des Erfassungssignals ausgewertet wird, vorzugsweise zeitabhängig und/oder durch einen Vergleich des Erfassungssignals unterschiedlicher der Sensorelemente (20, 30), um ein für den Ort der Aktivierung am Sensorelement (20, 30) charakteristisches Merkmal zu identifizieren, um wenigstens eine Funktion des Fahrzeuges (1) in Abhängigkeit von dem Ort und/oder eine Bewegung der Aktivierung zu aktivieren.

12. Computerprogramm, umfassend Befehle, die bei der Ausführung des Computerprogramms durch eine Verarbeitungsvorrichtung (50) diese veranlassen, die Schritte eines Verfahrens nach einem der vorhergehenden Ansprüche auszuführen.

## Claims

1. Sensor arrangement (10) for capacitive sensing in a vehicle (1), in particular for a door handle (2a) or an emblem (2b) or a sill (2c) or a bumper (2d) of the vehicle (1), comprising:
- at least one electrically conductive sensor element (20, 30) for providing capacitive sensing of the environment surrounding the sensor element (20, 30),
wherein the sensor element (20, 30) is each formed with a spatially resolving geometry (21) to obtain location-dependent information during detection,
wherein the sensor element (20, 30) is each formed as a wedge-shaped sensor electrode (20, 30), and wherein a first sensor element (20) of the at least one sensor element (20, 30) is arranged adjacent to a second sensor element (30) of the at least one sensor element (20, 30) such that the first and second sensor elements (20, 30) together provide a rectangular detection area (11), wherein one or at least two of the at least one sensor element (20, 30) each has electrically conductive fishbone ribs to form a fishbone shape (II.),
wherein the second sensor element (30) serves as a reference and is arranged with a reverse direction vector with respect to the gradual progression, complementary to the first sensor element (20), wherein both sensor elements (20, 30) have the same wedge shape.

2. Sensor arrangement (10) according to claim 1,
wherein the sensor element (20, 30) is each formed as at least one electrically conductive surface, in particular on a printed circuit board (12), to provide a variable capacitance for capacitive sensing, wherein the spatially resolving geometry (21) is formed as a geometric adaptation of this surface to adapt the variability of the capacitance in a spatially dependent manner.

3. Sensor arrangement (10) according to one of the preceding claims,
wherein the spatially resolving geometry (21) is formed as an asymmetry of an active sensor surface of the respective sensor element (20) to provide, at different positions of the sensor surface, a different, preferably gradually increasing, variability of capacitance in the sensor element (20), wherein the different variability is specific to the location-dependent information.

4. Sensor arrangement (10) according to any of the preceding claims,
wherein the sensor element (20) is configured in each case to have location-dependent sensitivity that varies, preferably increasing gradually and/or being predetermined, in order to provide the location-dependent information based on the varying sensitivity.

5. Sensor arrangement (10) according to any of the preceding claims,
wherein the at least one sensor element (20) is connected to a processing device (50) in each case to determine the location-dependent information by means of an electrical evaluation of the respective sensor element (20), in particular by evaluating a variable capacitance, in order to preferably detect a gesture and/or an activation combination based on the location-dependent information and/or to activate a safety-related function in the vehicle
and wherein the at least one sensor element (20, 30) comprises a first (20) and second (30) sensor element, which are arranged immediately adjacent to one another on a printed circuit board (12), in order to provide the capacitive detection synergistically through both sensor elements (20, 30) together, wherein the sensor elements (20, 30) are preferably arranged geometrically complementary to one another for this purpose.

6. Sensor arrangement (10) according to one of the preceding claims,
wherein the at least one sensor element (20, 30) comprises at least two sensor elements (20, 30) that are electrically separated from one another and/or connected separately to a processing device (50) so that each is electrically evaluated by the processing device (50) to determine and/or process a detection signal specific to the respective capacitive detection, wherein the detection signal preferably carries location-dependent information
and wherein the at least one sensor element (20, 30) comprises at least a first and a second sensor element (20, 30), wherein an electronic processing device (50) is connected to the sensor elements (20, 30) to evaluate the second sensor element (30) as a reference to the first sensor element (20) for providing the location-dependent information
and/or that the at least one sensor element (20) is respectively configured to provide the position resolution for a predetermined direction (B1, B2).

7. The sensor arrangement (10) according to one of the preceding claims,
wherein a processing device (50) is connected to the at least one sensor element (20) to repeatedly detect a detection signal from the respective sensor element (20) and to evaluate a temporal change in the detection signal to determine the location-dependent information
and wherein the at least one sensor element (20, 30) comprises at least one or more sensor elements (20, 30), each of which is electrically connected to a processing device (50) for repeatedly performing charge transfer, in order to evaluate, based on the charge transfer, a change in the variable capacitance provided by the respective sensor element (20, 30), which is specific to an approach to the sensor element (20, 30)
and that the at least one sensor element (20, 30) comprises at least two sensor elements (20, 30) that are geometrically identical
and/or that a processing device (50) is connected to the at least one sensor element (20) to detect, based on an evaluation of the location-dependent information, interference, preferably environmental influences, in particular rain, during capacitive detection.

8. Vehicle component (2), in particular a door handle (2a) or a bumper (2d), with a sensor arrangement (10) for capacitive sensing on the vehicle component (2),
comprising:
- at least one electrically conductive sensor element (20, 30) to provide capacitive sensing for the vicinity of the sensor element (20, 30),
wherein the sensor element (20, 30) is each formed with a spatially resolving geometry (21) to obtain location-dependent information during detection,
wherein the sensor arrangement (10) is configured according to one of the preceding claims.

9. Method for evaluating a sensor arrangement (10) for capacitive sensing in a vehicle (1), in particular for a door handle (2a) or an emblem (2b) or a sill (2c) or a bumper (2d) of the vehicle (1), wherein
the sensor arrangement (10) comprises at least one electrically conductive sensor element (20, 30) to provide capacitive sensing for the vicinity of the sensor element (20, 30), wherein
the sensor element (20, 30) is each designed with a spatially resolving geometry (21) to obtain location-dependent information during detection,
wherein the following steps are performed to evaluate the respective sensor element (20, 30), in particular by an electronic processing device (50):
- detecting a detection signal by initiating at least one charge transfer in the sensor element (20, 30),
- performing a comparison with an activation threshold for the detection signal,
- detecting an activation of the sensor element (20, 30) if the activation threshold is exceeded in the comparison,
wherein the sensor arrangement (10) is configured according to one of the preceding claims.

10. The method according to one of the preceding claims,
wherein the at least one sensor element (20, 30) comprises at least a first and a second sensor element (20, 30), for each of which activation is detected during the respective evaluation, wherein, in a further step, the temporally overlapping and/or successive activations of different sensor elements (20, 30) are compared with one another to detect an activation combination of these activations, in order to activate different functions of the vehicle (1) for different activation combinations.

11. The method according to any one of the preceding claims,
wherein the location-dependent information is obtained by evaluating an amplitude of the detection signal upon detection of the activation, preferably in a time-dependent manner and/or by comparing the detection signals of different sensor elements (20, 30), in order to identify a characteristic specific to the location of the activation on the sensor element (20, 30), in order to activate at least one function of the vehicle (1) depending on the location and/or a movement of the activation.

12. A computer program comprising instructions which, when the computer program is executed by a processing device (50), cause the processing device to perform the steps of a method according to one of the preceding claims.

## Revendications

1. Dispositif de capteurs (10) destiné à la détection capacitive sur un véhicule (1), en particulier pour une poignée de porte (2a), un emblème (2b), un seuil (2c) ou un pare-chocs (2d) du véhicule (1),
comprenant :
- au moins un élément capteur électriquement conducteur (20, 30) destiné à assurer respectivement la détection capacitive de l'environnement de l'élément capteur (20, 30),
dans lequel l'élément capteur (20, 30) est formé respectivement avec une géométrie à résolution spatiale (21) afin d'obtenir une information dépendante de la position lors de la détection,
l'élément capteur (20, 30) étant formé respectivement comme une électrode de capteur en forme de coin (20, 30), et un premier élément capteur (20) dudit au moins un élément capteur (20, 30) est disposé de telle sorte à proximité d'un deuxième élément capteur (30) dudit au moins un élément capteur (20, 30) que les premier et deuxième éléments capteurs (20, 30) fournissent conjointement une zone de détection rectangulaire (11), l'un ou au moins deux desdits au moins un élément capteur (20, 30) comportant chacun des arêtes électriquement conductrices pour former une forme en arête de poisson (II.),
le deuxième élément capteur (30) servant de référence et étant disposé avec un vecteur de direction inversé par rapport à la courbe graduelle, de manière complémentaire au premier élément capteur (20), les deux éléments capteurs (20, 30) présentant la même forme en coin.

2. Dispositif de capteurs (10) selon la revendication 1,
dans lequel l'élément capteur (20, 30) est réalisé respectivement sous la forme d'au moins une surface électriquement conductrice, en particulier sur une carte de circuit imprimé (12), afin de fournir une capacité variable pour la détection capacitive, la géométrie à résolution spatiale (21) étant réalisée sous la forme d'une adaptation géométrique de cette surface afin d'adapter la variabilité de la capacité en fonction de l'emplacement.

3. Dispositif de capteurs (10) selon l'une des revendications précédentes,
dans lequel la géométrie à résolution spatiale (21) est réalisée sous la forme d'une asymétrie d'une surface de capteur active de l'élément de capteur respectif (20) afin de fournir, en différents points de la surface de capteur, une variabilité différente, de préférence croissante de manière graduelle, de la capacité au niveau de l'élément de capteur (20), la variabilité différente étant spécifique à l'information dépendante de la position.

4. Dispositif de capteurs (10) selon l'une des revendications précédentes,
dans lequel l'élément de capteur (20) est conçu de manière à présenter, en fonction de l'emplacement, une sensibilité variable, de préférence croissante de manière graduelle et/ou prédéfinie, afin de fournir les informations dépendantes de l'emplacement sur la base de cette sensibilité variable.

5. Dispositif de capteurs (10) selon l'une des revendications précédentes,
dans lequel le ou les éléments de capteur (20) sont chacun connectés à un dispositif de traitement (50) afin de déterminer les informations dépendantes de l'emplacement par une évaluation électrique de l'élément de capteur (20), en particulier par une évaluation d'une capacité variable, afin de détecter de préférence, sur la base des informations dépendantes de la position, un geste et/ou une combinaison d'activation et/ou d'activer une fonction de sécurité sur le véhicule
et en ce que ledit au moins un élément capteur (20, 30) comprend un premier (20) et un deuxième (30) élément capteur qui sont disposés de manière immédiatement adjacente l'un à l'autre sur une carte de circuit imprimé (12) afin de fournir conjointement et de manière synergique la détection capacitive par les deux éléments capteurs (20, 30), les éléments capteurs (20, 30) étant de préférence disposés de manière géométriquement complémentaire l'un par rapport à l'autre.

6. Dispositif de capteurs (10) selon l'une des revendications précédentes,
dans lequel l'au moins un élément de capteur (20, 30) comprend au moins deux éléments de capteur (20, 30) qui sont séparés électriquement l'un de l'autre et/ou connectés séparément l'un de l'autre à un dispositif de traitement (50) afin d'être évalués électriquement respectivement par le dispositif de traitement (50) afin de déterminer et/ou de traiter respectivement un signal de détection spécifique à la détection capacitive correspondante, le signal de détection portant de préférence l'information liée à la localisation
et en ce que ledit au moins un élément capteur (20, 30) comprend au moins un premier et un deuxième élément capteur (20, 30), un dispositif de traitement électronique (50) étant connecté aux éléments capteurs (20, 30) afin d'évaluer le deuxième élément capteur (30) comme référence par rapport au premier élément capteur (20) pour fournir les informations dépendantes de la position
et/ou que ledit au moins un élément capteur (20) est conçu pour fournir la résolution de localisation pour une direction prédéfinie (B1, B2).

7. Dispositif de capteurs (10) selon l'une des revendications précédentes,
dans lequel un dispositif de traitement (50) est connecté à l'au moins un élément capteur (20) afin de détecter de manière répétée un signal de détection de l'élément capteur respectif (20) et d'évaluer une variation temporelle du signal de détection pour déterminer les informations dépendantes de la position
et en ce que l'au moins un élément capteur (20, 30) comprend au moins un ou plusieurs éléments capteurs (20, 30), qui sont chacun connectés électriquement à un dispositif de traitement (50) pour effectuer de manière répétée un transfert de charge, afin d'évaluer, sur la base du transfert de charge, une variation de la capacité variable fournie respectivement par l'élément capteur (20, 30), qui est spécifique à un rapprochement de l'élément capteur (20, 30)
et que ledit au moins un élément capteur (20, 30) comprend au moins deux éléments capteurs (20, 30) qui sont de conception géométrique identique
et/ou qu'un dispositif de traitement (50) est connecté à l'au moins un élément capteur (20) afin de détecter, à l'aide d'une évaluation des informations liées à la localisation, des influences perturbatrices, de préférence des influences environnementales, en particulier la pluie, lors de la détection capacitive.

8. Composant de véhicule (2), en particulier poignée de porte (2a) ou pare-chocs (2d), comportant un agencement de capteurs (10) pour une détection capacitive au niveau du composant de véhicule (2),
comprenant :
- au moins un élément capteur électriquement conducteur (20, 30) pour assurer respectivement la détection capacitive pour un environnement de l'élément capteur (20, 30),
l'élément capteur (20, 30) étant formé avec une géométrie à résolution spatiale (21) afin d'obtenir une information dépendante de la position lors de la détection,
l'agencement de capteurs (10) étant conçu selon l'une des revendications précédentes.

9. Procédé d'évaluation d'un dispositif de capteurs (10) pour une détection capacitive sur un véhicule (1), en particulier pour une poignée de porte (2a) ou un emblème (2b) ou un seuil (2c) ou un pare-chocs (2d) du véhicule (1), dans lequel
le dispositif de capteurs (10) comporte au moins un élément de capteur électriquement conducteur (20, 30) afin d'assurer respectivement la détection capacitive pour un environnement de l'élément de capteur (20, 30),
l'élément capteur (20, 30) est formé avec une géométrie à résolution spatiale (21) afin d'obtenir une information dépendante de la position lors de la détection,
les étapes suivantes étant exécutées pour l'évaluation de l'élément capteur respectif (20, 30), en particulier par un dispositif de traitement électronique (50) :
- Détection d'un signal de détection par le déclenchement d'au moins un transfert de charge au niveau de l'élément capteur (20, 30),
- effectuer une comparaison avec un seuil d'activation pour le signal de détection,
- détecter une activation de l'élément capteur (20, 30) lorsque le seuil d'activation est dépassé lors de la comparaison,
le dispositif de capteurs (10) étant conçu selon l'une des revendications précédentes.

10. Procédé selon l'une des revendications précédentes,
dans lequel ledit au moins un élément capteur (20, 30) comprend au moins un premier et un deuxième éléments capteurs (20, 30), pour lesquels l'activation est respectivement détectée lors de l'évaluation correspondante, les activations se chevauchant dans le temps et/ou successives de différents éléments capteurs (20, 30) sont comparées entre elles afin de détecter une combinaison d'activations de ces activations, pour activer différentes fonctions du véhicule (1) en fonction des différentes combinaisons d'activations.

11. Procédé selon l'une des revendications précédentes,
dans lequel l'information dépendante de l'emplacement est obtenue en évaluant, lors de la détection de l'activation, une amplitude du signal de détection, de préférence en fonction du temps et/ou par une comparaison du signal de détection de différents éléments capteurs (20, 30), afin d'identifier une caractéristique propre à l'emplacement de l'activation sur l'élément capteur (20, 30), afin d'activer au moins une fonction du véhicule (1) en fonction de l'emplacement et/ou d'un mouvement de l'activation.

12. Programme informatique comprenant des instructions qui, lors de l'exécution du programme informatique par un dispositif de traitement (50), amènent celui-ci à exécuter les étapes d'un procédé selon l'une des revendications précédentes.
